# EUROPEAN PATENT APPLICATION

(11) **EP 2 675 065 A2**
(43) Date of publication of application: **18.12.2013**
(21) Application number: 13153332.5
(22) Date of filing: 30.01.2013
(51) Int. Cl.: H03H 11/12

(54) **Electronic apparatus, filter adjustment apparatus, filter adjustment method, and filter adjustment program**

(30) Priority: 15.06.2012 JP 2012135766
(71) Applicant: Kabushiki Kaisha Toshiba, Tokyo 105-8001 (JP)
(72) Inventor: Iwata, Shigeyasu, Tokyo 105-8001 (JP)
(74) Representative: Henkel, Breuer & Partner

(57) **Abstract**

According to one embodiment, a filter adjustment apparatus includes a filter adjustment module (105) and a setting module (112). The filter adjustment module (105) is configured to set a plurality of current values in a filter, and to detect adjustment results of characteristics of the filter at the plurality of current values. The setting module (112) is configured to set, when an adjustment result detected at a current value smaller than a reference value of the plurality of current values satisfies a preset condition with respect to a reference adjustment result detected at the reference current value, the current value smaller than the reference current value in the filter.

## Description

Embodiments described herein relate generally to an electronic apparatus, filter adjustment apparatus, filter adjustment method, and filter adjustment program.

For example, a filter circuit used in a wireless communication field extracts desired frequency components from a received signal. A receiver including a filter circuit of this type is normally manufactured as an integrated circuit. In many filter circuits, the filter characteristics are determined by a resistor and a capacitor. However, the resistor and capacitor are subject to manufacturing variations, so that the actual resistance and capacitance differ from the design values.

Manufacturing variations in the capacitor and resistor cause variations of the filter characteristics, and the desired characteristics often cannot be obtained. When this happens In wireless communication, it is difficult to extract a signal of a desired frequency or to sufficiently remove interfering frequencies, resulting in considerable fluctuations in the characteristics of a wireless device. To avoid this, when filter characteristics vary, a technique for automatically adjusting them to those desired has been proposed.

For example, a reference signal of a given amplitude is input to a filter circuit, filter output amplitudes after making various adjustments to the filter characteristics are detected, and filter characteristics related to the maximum amplitude are selected. Alternatively, reference signals of a plurality of different amplitudes are input to a filter circuit, filter output amplitudes after making various adjustments to the filter characteristics are detected, and filter characteristics related to the maximum amplitude are selected. Thus, even when gains are subject to variation, adjustment can be attained at constant precision using amplitudes. A filter can be adjusted using amplitude detection without using phase comparison or Q-value adjustment.

Because of the miniaturization of integrated circuits, variations in performance and power consumption of filters implemented as integrated circuits can be great, and measures against such variations are demanded.

While the conventional technique of automatically adjusting filter characteristics allows variations in the frequency characteristics of a filter circuit to be adjusted, it is not easy to adjust variations in power consumption. That is, it is not easy to optimize the power consumption of a filter circuit.

A general architecture that implements the various features of the embodiments will now be described with reference to the drawings. The drawings and the associated descriptions are provided to illustrate the embodiments and not to limit the scope of the invention.
FIG. 1 is a view showing the outer appearance of an example of a digital television broadcast receiver as an application example of an automatic filter adjustment apparatus according to the first embodiment;
FIG. 2 is a block diagram showing an example of the digital television broadcast receiver;
FIG. 3 is a block diagram showing an example of an automatic filter adjustment apparatus according to the first embodiment;
FIG. 4 is a flowchart showing an example of an adjustment mode of the first embodiment;
FIG. 5 is a table showing the relationship between respective frequency characteristics stored in the adjustment mode of the first embodiment, and a plurality of reference signals of different amplitudes;
FIG. 6 is a diagram showing an example of the arrangement of a reference signal generator (an example using a sine wave) according to the first embodiment;
FIG. 7 is a diagram showing another example of the arrangement of the reference signal generator (an example using a rectangular wave) according to the first embodiment;
FIG. 8 is a diagram showing still another example of the arrangement of the reference signal generator (an example using a plurality of reference signals of different frequencies) according to the first embodiment;
FIG. 9 is a circuit diagram showing an example of the arrangement of a filter according to the first embodiment;
FIG. 10 is a diagram showing an example of the arrangement of an amplitude detector according to the first embodiment;
FIG. 11 is a block diagram showing an example of an automatic filter adjustment apparatus according to the second embodiment;
FIG. 12 is a block diagram showing an example of an automatic filter adjustment apparatus according to the third embodiment; and
FIG. 13 is a block diagram showing an example of a power supply control system according to the fourth embodiment.

Various embodiments will be described hereinafter with reference to the accompanying drawings.

In general, according to one embodiment, a filter adjustment apparatus includes a filter adjustment module and a setting module. The filter adjustment module is configured to set a plurality of current values in a filter, and to detect adjustment results of characteristics of the filter at the plurality of current values. The setting module is configured to set, when an adjustment result detected at a current value smaller than a reference value of the plurality of current values satisfies a preset condition with respect to a reference adjustment result detected at the reference current value, the current value smaller than the reference current value in the filter.

### (First Embodiment)

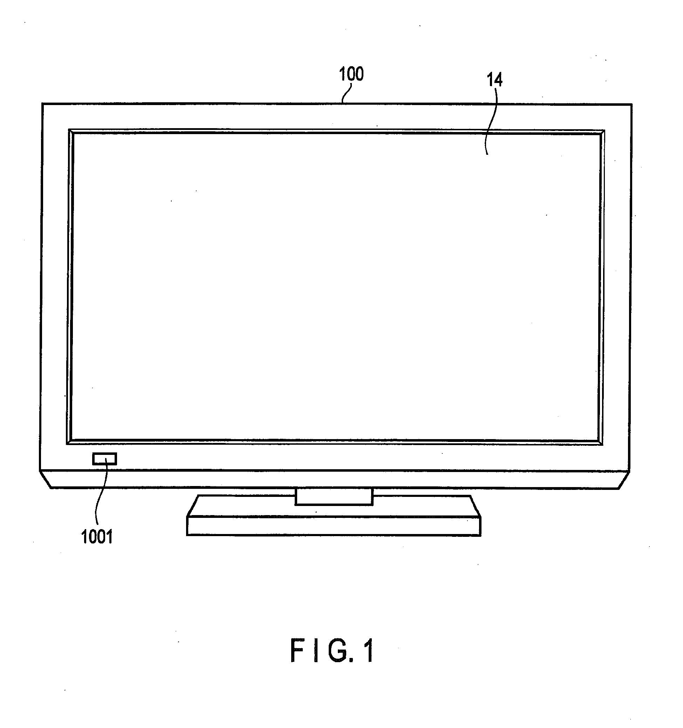

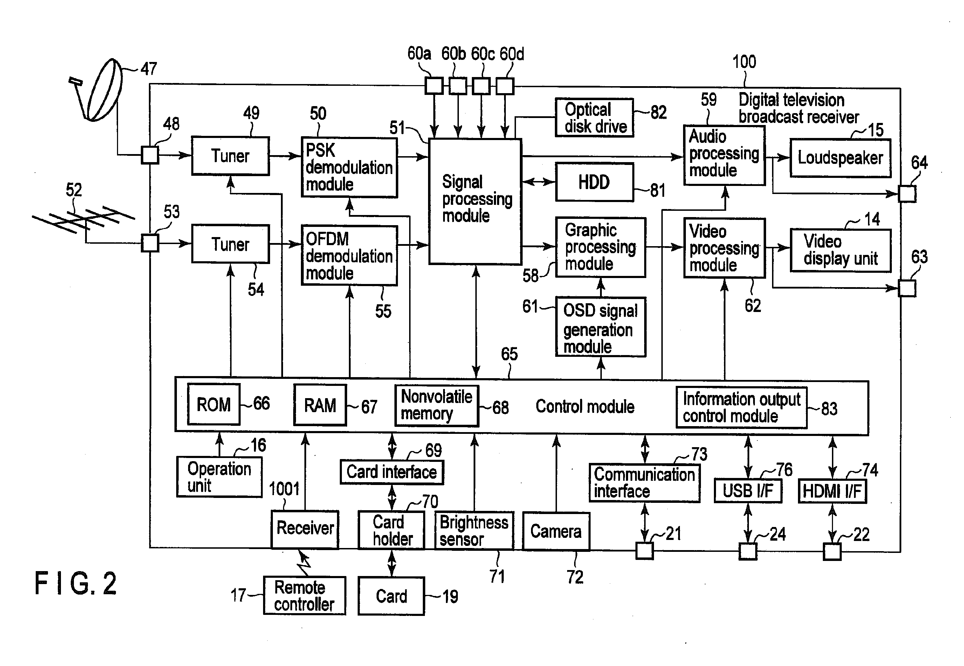

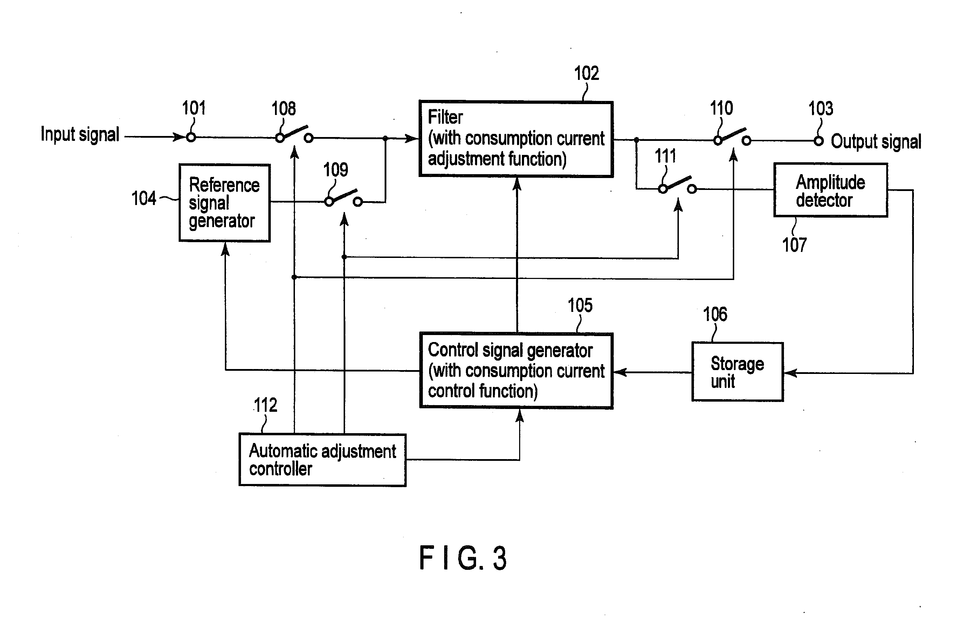

FIG. 1 shows the outer appearance of an example of a digital television broadcast receiver as an application example of an automatic filter adjustment apparatus according to the first embodiment. FIG. 2 is a block diagram showing an example of this digital television broadcast receiver. Note that the automatic filter adjustment apparatus will be described in detail later with reference to FIG. 3. In the first embodiment, a case will be exemplified wherein the automatic filter adjustment apparatus shown in FIG. 3 is applied to the digital television broadcast receiver. However, the automatic filter adjustment apparatus can also be applied to a digital recorder or the like which does not include a display as an indispensable component.

As shown in FIG. 2, a satellite digital television broadcast signal, which is received by a DBS digital broadcast receiving antenna 47, is supplied to a satellite digital broadcast tuner 49 via an input terminal 48, and the tuner 49 tunes a broadcast signal of a designated channel.

The broadcast signal tuned by this tuner 49 is supplied to a phase shift keying (PSK) demodulation module 50, and is demodulated to obtain a digital video signal and audio signal, which are then output to a signal processing module 51.

A terrestrial digital television broadcast signal, which is received by a terrestrial broadcast receiving antenna 52, is supplied to a terrestrial digital broadcast tuner 54 via an input terminal 53, and the tuner 54 tunes a broadcast signal of a designated channel.

The broadcast signal tuned by this tuner 54 is supplied to an orthogonal frequency division multiplexing (OFDM) demodulation module 55, and is demodulated to obtain a digital video signal and audio signal, which are then output to the signal processing module 51.

The signal processing module 51 selectively applies predetermined digital signal processing to the digital video and audio signals respectively supplied from the PSK demodulation module 50 and OFDM demodulation module 55, and outputs the processed signals to a graphic processing module 58 and audio processing module 59.

To the signal processing module 51, a plurality of (four in FIG. 2) input terminals 60a, 60b, 60c, and 60d are connected. These input terminals 60a to 60d allow to respectively input analog video and audio signals from a device outside a digital television broadcast receiver 100.

The signal processing module 51 selectively converts the analog video and audio signals respectively supplied from the input terminals 60a to 60d into digital video and audio signals, applies predetermined digital signal processing to the digital video and audio signals, and then outputs these signals to the graphic processing module 58 and audio processing module 59.

Of these processing modules, the graphic processing module 58 has a function of superimposing an on-screen display (OSD) signal generated by an OSD signal generation module 61 on the digital video signal supplied from the signal processing module 51, and outputting that signal. This graphic processing module 58 can selectively output the output video signal of the signal processing module 51 and the output OSD signal of the OSD signal generation module 61, or can combine and output these outputs.

The digital video signal output from the graphic processing module 58 is supplied to a video processing module 62. The video signal processed by the video processing module 62 is supplied to a video display unit 14, and also to an output terminal 63. The video display unit 14 displays an image based on the video signal. When an external device is connected to the output terminal 63, the video signal supplied to the output terminal 63 is input to the external device.

The audio processing module 59 converts the input digital audio signal into an analog audio signal which can be played back by loudspeakers 15, and outputs the analog audio signal to the loudspeakers 15 to output a sound and also externally outputs it via an output terminal 64.

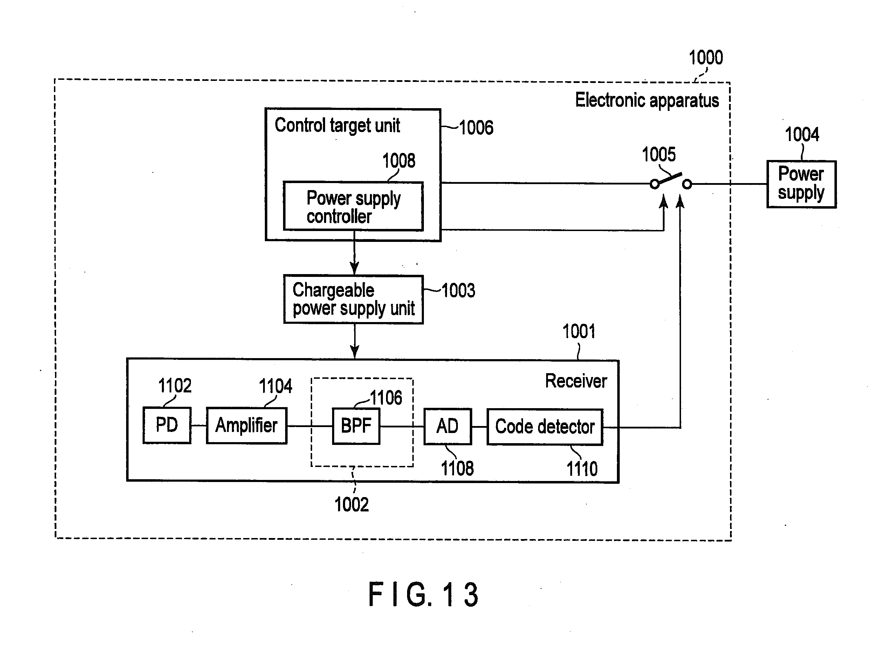

Note that a control module 65 of the digital television broadcast receiver 100 integrally controls all processes and operations including the aforementioned signal processes and the like. The control module 65 includes a central processing unit (CPU) and the like. The control module 65 controls respective modules based on operation information from an operation unit 16 or that which is output from a remote controller 17 and is received via a receiver 1001, so as to reflect the operation contents. For example, the automatic filter adjustment apparatus shown in FIG. 3 can be applied to the receiver 1001. The automatic filter adjustment apparatus will be described in detail later with reference to FIG. 3. Also, the receiver 1001 will be described in detail later with reference to FIG. 13.

In this case, the control module 65 mainly uses a read-only memory (ROM) 66 which stores control programs executed by the CPU, a random access memory (RAM) 67 which provides a work area to the CPU, and a nonvolatile memory 68 which stores various kinds of setting information, control information, and the like.

This control module 65 is connected to a card holder 70, which can receive a memory card 19, via a card interface 69. Thus, the control module 65 can exchange information with the memory card 19 attached to the card holder 70 via the card interface 69.

Also, the control module 65 is connected to a LAN terminal 21 via a communication interface 73. Thus, the control module 65 can exchange information via a LAN cable connected to the LAN terminal 21 and the communication interface 73. For example, the control module 65 can receive contents transmitted from a server via the LAN cable and communication interface 73.

Furthermore, the control module 65 is connected to an HDMI terminal 22 via an HDMI interface 74. Thus, the control module 65 can exchange information with HDMI-compatible devices connected to the HDMI terminal 22 via the HDMI interface 74.

Moreover, the control module 65 is connected to a USB terminal 24 via a USB interface 76. Thus, the control module 65 can exchange information with USB-compatible devices (such as a digital camera and digital video camera) connected to the USB terminal 24 via the USB interface 76.

In addition, the control module 65 refers to video recording reservation information included in a video recording reservation list stored in the nonvolatile memory 68, and controls a video recording operation of a content based on a reception signal. As a video recording destination, for example, a built-in HDD 81, an external HDD connected via the USB terminal 24, and a Blu-ray recorder connected via the HDMI terminal are available.

Furthermore, the control module 65 instructs an optical disk drive 82 to play back an optical disk based on operation information (optical disk playback instruction) from the operation unit 16 or that (optical disk playback instruction) which is output from the remote controller 17 and is received via the receiver 1001. In response to this instruction, the optical disk drive 82 reads out data from the optical disk.

Also, the control module 65 controls the brightness of a backlight of the video display unit 14 based on a brightness detection level from a brightness sensor 71. The control module 65 turns on or off the image on the video display unit 14 by determining the presence/absence of a user at an opposing position of the video display unit 14 based on moving image information from a camera 72.

FIG. 3 is a block diagram of the automatic filter adjustment apparatus according to the first embodiment. The automatic filter adjustment apparatus has an input terminal 101, filter 102, output terminal 103, reference signal generator 104, control signal generator 105, storage unit 106, amplitude detector 107, switches 108, 109, 110, and 111, and automatic adjustment controller 112. Note that the filter 102 includes a consumption current adjustment function, and the control signal generator 105 includes a consumption current control function, as will be described in detail later.

The input terminal 101 is used to input an external input signal to the filter 102. The input terminal 101 is connected to that of the filter 102 via switch 108. The reference signal generator 104 generates reference signals of a plurality of different amplitudes. Details of the reference signals generated by the reference signal generator 104 will be described later. The reference signals output from the reference signal generator 104 are input to the filter 102 via switch 109.

The output signal of the filter 102 is input to the amplitude detector 107 via switch 111, and is supplied to the output terminal 103 via switch 110. The amplitude detector 107 detects the amplitude of the output signal of the filter 102. Details of the amplitude detector 107 will be described later. The output terminal 103 is used to externally output the output signal of the filter 102.

The filter 102 includes a control terminal which receives a filter characteristic control signal (characteristic control value) output from the control signal generator 105, and can adjust its characteristics (characteristic frequency) according to this filter characteristic control signal. As the filter 102, a low-pass filter, high-pass filter, bandpass filter, or the like is used. The characteristic frequency is a frequency indicating filter characteristics. For example, in the case of a bandpass filter, a center frequency of a pass band corresponds to the characteristic frequency, and in the case of a low-pass filter or high-pass filter, a cutoff frequency corresponds to the characteristic frequency. Details of the arrangement of the filter 102 will be described later.

The detection result of the amplitude detector 107 is written to the storage unit 106, and data read out from the storage unit 106 is supplied to the control signal generator 105. The control signal generator 105 is controlled by an automatic adjustment signal from the automatic adjustment controller 112 (for example, a CPU or the like), and outputs the filter characteristic control signal required to control the characteristic frequency of the filter 102, and an amplitude control signal required to control the amplitude of the reference signal generated by the reference signal generator 104. Therefore, the characteristic frequency of the filter 102 and the amplitude of the reference signal generated by the reference signal generator 104 are controlled by the control signal generator 105. Also, the filter characteristic control signal and amplitude control signal are given as signals which change discretely, for example, digital signals. Furthermore, the control signal generator 105 decides the filter characteristic control signal which controls the characteristic frequency of the filter to match a desired characteristic frequency according to data read out from the storage unit 106 (to be described later).

The automatic adjustment controller 112 outputs automatic adjustment control signals required to control switches 108, 109, 110, and 111 and the control signal generator 105. Switches 108, 109, 110, and 111 are turned on or off in response to the automatic adjustment control signals. For example, when an input signal from the input terminal 101 is input to the filter 102, switches 108 and 110 are turned on, and switches 109 and 111 are turned off. Conversely, when switches 108 and 110 are turned off and switches 109 and 111 are turned on, the reference signal from the reference signal generator 104 is input to the filter 102. When the reference signal output from the reference signal generator 104 is stopped to be input to the filter 102, a unit which directly stops outputting of the reference signal from the reference signal generator 104 without using switch 109 may be included.

By turning switches 108 and 110 and switches 109 and 111 on or off, the automatic filter adjustment apparatus of the first embodiment is switched between two modes, that is, an operation mode and adjustment mode.

In the adjustment mode, a filter characteristic control signal required to set the filter characteristics to be desired characteristics is decided based on the amplitudes of output signals of the filter when the reference signals of the plurality of different amplitudes are input to the filter 102 set in a plurality of filter characteristics. In the adjustment mode, switches 108 and 110 are turned off, and switches 109 and 111 are turned on by the automatic adjustment controller 112. The reference signal output from the reference signal generator 104 is input to the filter 102 via switch 109. The input reference signal is processed by the filter 102, and an output is input to the amplitude detector 107.

The amplitude detector 107 detects the amplitude of the output signal of the filter 102, and stores a detection result in the storage unit 106. More specifically, at respective characteristic frequencies set by changing a filter characteristic frequency level by level, the output amplitude of the reference signal is changed level by level, the amplitudes of the outputs of the filter 102 are detected in all combinations of all the filter characteristic frequencies and all the reference signals of the different amplitudes, and the amplitudes of the filter outputs in all the combinations are written to the storage unit 106 in association with the output amplitudes of the reference signals and filter characteristic control signals (characteristic frequencies to be set).

By detecting the amplitudes of the filter outputs while changing the filter characteristics using the reference signals of the plurality of different amplitudes a large number of times in this way, even when filter characteristics are subject to variations, if a difference is detected in the filter output associated with a reference signal of any amplitude, the filter characteristics can be adjusted with high precision without detecting any phase.

The operation mode corresponds to a state in which an input signal from the input terminal 101 is input to the filter 102 via switch 108. To the control terminal of the filter 102, the filter characteristic control signal decided in the adjustment mode is supplied from the control signal generator 105. In the operation mode, the filter 102 extracts a desired frequency and removes unwanted frequency components from the input signal from the input terminal 101, and outputs the output signal of itself from the output terminal 103.

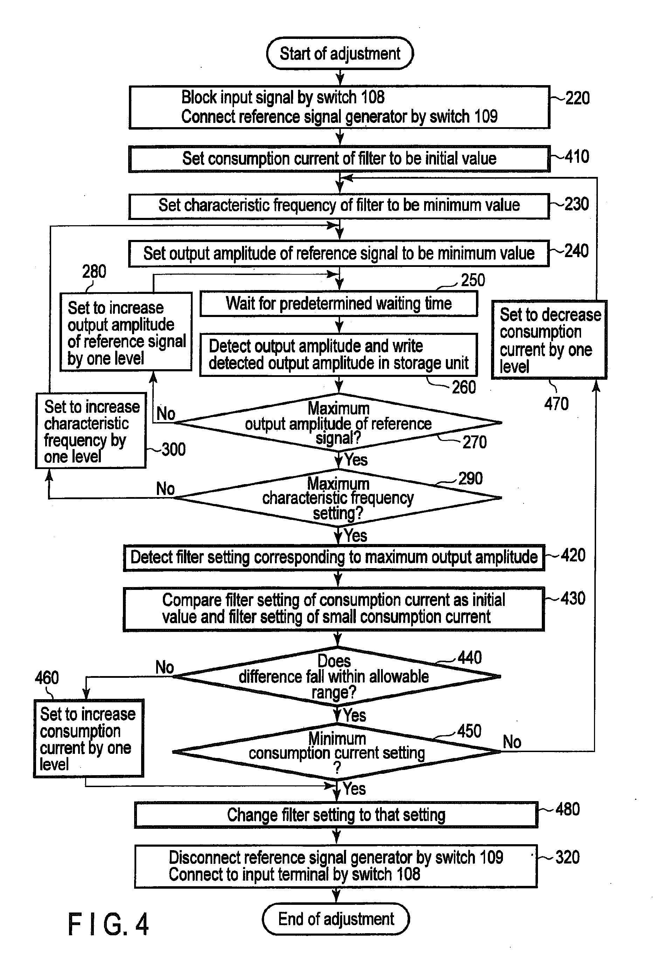

FIG. 4 is a flowchart associated with the adjustment mode of the first embodiment.

In block 220, the automatic adjustment controller 112 turns off switches 108 and 110 and turns off switches 109 and 111 to block an input signal from the input terminal 101, and to input the reference signal from the reference signal generator 104 to the filter 102. In block 410, the control signal generator 105 sets a consumption current of the filter 102 to be an initial value (reference current value). For example, the initial value is a maximum one of a plurality of current values to be set, that is, 1 mA. In block 230, the control signal generator 105 supplies a filter characteristic control signal required to set a characteristic frequency to be a minimum value of settable frequencies to the filter 102. The filter characteristic control signal output from the control signal generator 105 is that which increases the resistance and capacitance of the filter 102 so as to control the characteristic frequency. If a resistor and capacitor are manufactured as designed, the characteristic frequency can be correctly set at a desired frequency by the control signal. However, when the resistor and capacitor are subject to manufacturing variations, the characteristic frequency cannot be set at a frequency to be set by the control signal.

In block 240, the control signal generator 105 supplies an amplitude control signal required to set an output amplitude of a reference signal to be generated by the reference signal generator 104 to be a minimum value of settable amplitudes to the reference signal generator 104.

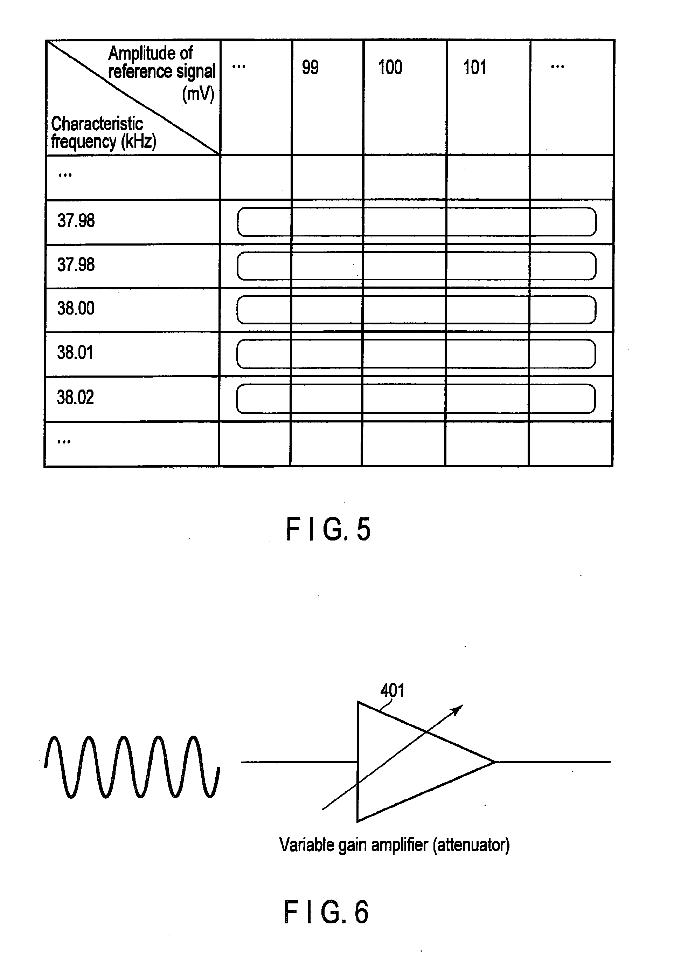

After the control waits for a predetermined waiting time until the filter 102 outputs a signal in block 250 so as to detect the amplitude of the output signal of the filter 102, the amplitude detector 107 detects the output signal of the filter 102, and writes the detected output amplitude to the storage unit 106 in block 260. The output amplitude of the filter 102 is stored in association with the output amplitude of the reference signal at the time of detection of that amplitude (or the amplitude control signal of the reference signal generator 104 at the time of detection of that amplitude), and the characteristic frequency to be set by the filter characteristic control signal (or the filter characteristic control signal of the control signal generator 105 at the time of detection of that amplitude). FIG. 5 illustrates a data storage state of the storage unit 106.

It is checked in block 270 whether or not the output amplitude of the reference signal output from the reference signal generator 104 is maximum. If the amplitude is not maximum, the control signal generator 105 increases the amplitude to be set by the amplitude control signal supplied to the reference signal generator 104 by one level (for example, by 1 mV) to set to increase the output amplitude of the output reference signal of the reference signal generator 104 by one level in block 280. Thus, the amplitude of the reference signal generated by the reference signal generator 104 is increased, and the flowchart returns to block 250.

If it is determined in block 270 that the amplitude to be set by the amplitude control signal is maximum, it is checked in block 290 whether or not the characteristic frequency of the filter to be set by the filter characteristic control signal is maximum. If the characteristic frequency of the filter to be set by the filter characteristic control signal is not maximum, the control signal generator 105 increases the characteristic frequency of the filter to be set by the filter characteristic control signal supplied to the filter 102 by one level (for example, by 0.01 kHz) in block 300. Thus, the filter characteristic frequency is increased, and the flowchart returns to block 240. With the above processing, when the characteristic frequency to be set by the filter characteristic control signal changes level by level from the minimum value to the maximum value, the output amplitude of the reference signal changes level by level from the minimum value to the maximum value at each frequency, and the detection value of the amplitude of the output signal of the filter 102 in each combination of the output amplitude of the reference signal and filter characteristic frequency is written to the storage unit 106, as shown in FIG. 5.

With the aforementioned sequence (block 410 and a loop of blocks 230 to 290), the output amplitudes of the filter 102 in all combinations of a plurality of different amplitude settings of the reference signal and a plurality of different characteristic frequency settings while the consumption current of the filter 102 assumes the initial value are detected, and are written to the storage unit 106 as a filter setting (reference filter setting). That is, the reference filter setting (adjustment result (reference adjustment result) of the filter characteristics) includes information associated with the output amplitudes of the filter 102 in all the combinations of the plurality of amplitude settings of the reference signal and the plurality of characteristic frequency settings while the consumption current assumes the initial value.

Subsequently, in block 420, the automatic adjustment controller 112 detects filter setting information corresponding to the maximum output amplitude of the filter 102 while the consumption current of the filter 102 assumes the initial value. The filter setting information includes a combination of a characteristic frequency (or filter characteristic control signal) and reference signal (or amplitude control signal of the reference signal), which maximizes the output amplitude of the filter 102, and also includes the maximum output amplitude value of the filter 102.

The flowchart advances to block 470, and the consumption current of the filter is decreased by one level (to change the reference current value to a current value smaller by one level than this reference current value) in block 470. With the same sequence (block 410 and the loop of blocks 230 to 290), the output amplitudes of the filter 102 in all combinations of a plurality of different amplitude settings of the reference signal and a plurality of different characteristic frequency settings while the consumption current of the filter assumes a small current value smaller by one level than the initial value are detected, and are written to the storage unit 106 as a filter setting (predetermined filter setting). That is, the predetermined filter setting (adjustment result (predetermined adjustment result) of the characteristics of the filter) includes information associated with the output amplitudes of the filter 102 in all the combinations of the plurality of different amplitude settings of the reference signal and the plurality of different characteristic frequency settings while the consumption current of the filter assumes the small current value smaller by one level than the reference current value.

Subsequently, in block 420, the automatic adjustment controller 112 detects filter setting information corresponding to the maximum output amplitude of the filter 102 while the consumption current of the filter 102 assumes the small current value smaller by one level than the initial value. The filter setting information includes a combination of a characteristic frequency (or filter characteristic control signal) and reference signal (or amplitude control signal of the reference signal), which maximizes the output amplitude of the filter 102, and also includes the maximum output amplitude value of the filter 102.

In block 430, the automatic adjustment controller 112 compares the reference filter setting (reference adjustment result) and the predetermined filter setting (predetermined adjustment result).

The automatic adjustment controller 112 determines whether or not the predetermined filter setting (predetermined adjustment result) detected at the small current value smaller by one level than the initial value satisfies a predetermined condition with respect to the reference filter setting (reference adjustment result) detected at the initial value. For example, the automatic adjustment controller 112 compares the reference filter setting and the predetermined filter setting, and determines that a preset condition is satisfied when the predetermined filter setting is included in an allowable range based on the reference filter setting. More specifically, as shown in block 440, the automatic adjustment controller 112 determines whether or not a difference between the reference filter setting and predetermined filter setting falls within an allowable range.

If the difference falls within the allowable range, the automatic adjustment controller 112 determines that a performance drop of the filter 102 caused by a decrease in consumption current of the filter 102 is minimal, and further decreases the consumption current by one level to repeat the same sequence (blocks 230 to 300, 420, and 430). Then, the automatic adjustment controller 112 detects a minimum consumption current corresponding to a difference which falls within the allowable range, sets this minimum consumption current in the filter 102, and sets filter characteristics (frequency characteristics) of the filter 102 based on the predetermined filter setting (predetermined adjustment result) obtained at this minimum consumption current. Note that even with a minimum consumption current setting controllable by the automatic filter adjustment apparatus, if a difference falls within the allowable range (YES in block 450), this controllable minimum consumption current is set in the filter 102, and the filter characteristics (frequency characteristics) of the filter 102 are set based on the predetermined filter setting (predetermined adjustment result) obtained at this minimum consumption current (block 480).

Note that the first embodiment will explain a case in which a minimum consumption current corresponding to a difference which falls within the allowable range is detected, and this minimum consumption current is set in the filter 102. However, the minimum consumption current need not always be detected, and for example, a consumption current smaller than the initial value need only be detected. This is because the consumption current smaller than the initial value can yield a consumption power reduction effect. Note that the first embodiment selects a maximum one of a plurality of settable current values as the initial value, but an arbitrary one of the plurality of settable current values may be selected as the initial value.

On the other hand, if the difference falls outside the allowable range (NO in block 440) as a result of a decrease in consumption current by one level, the consumption current is increased by one level (block 460), the consumption current increased by one level is set in the filter 102, and the filter characteristics (frequency characteristics) of the filter 102 are set based on the predetermined filter setting (predetermined adjustment result) obtained at this consumption current increased by one level (block 480). Note that in block 460, the consumption current is increased by a predetermined level (for example, 0.05 or 0.01 mA) smaller than one level (for example, 0.1 mA) until the difference is included in the allowable range. In this manner, an optimal consumption current may be detected.

Note that the case has been described above wherein the current value is decreased by a predetermined value level by level to detect the minimum current value (the case in which the minimum current value is detected by a so-called linear search). However, the filter adjustment of the first embodiment is not limited to the linear search. For example, the minimum current value may be detected by a so-called binary search. In the binary search, for example, it is determined first whether or not a condition is satisfied by a maximum current value. If the condition is satisfied by the maximum current value, it is then determined whether or not the condition is satisfied by a minimum current value. If the condition is satisfied by the minimum current value, the minimum current value is decided.

If the condition is not satisfied by the minimum current value, it is determined whether or not the condition is satisfied by a first current value as an intermediate value between the maximum and minimum current values, so as to increase the current value. If the condition is not satisfied either by the first current value, it is determined whether or not the condition is satisfied by a second current value as an intermediate value between the maximum current value and first current value, so as to further increase the current value. If the condition is satisfied by the first current value, it is determined whether or not the condition is satisfied by a third current value as an intermediate value between the first current value and minimum current value, so as to decrease the current value. In this manner, when the condition is satisfied, the current value is decreased to search for a minimum current value which satisfies the condition; when the condition is not satisfied, the current value is increased to search for a minimum current value which satisfies the condition.

An example of the method of determining whether or not a difference between the reference filter setting (reference adjustment result) and predetermined filter setting (predetermined adjustment result) falls within the allowable range will be described below. For example, the automatic adjustment controller 112 determines whether or not a difference between a sum total of detection results by all gain settings at an identical characteristic frequency setting, which are obtained at a consumption current of the initial value, and that of detection results by all gain settings at an identical characteristic frequency setting, which are obtained at a predetermined small consumption current, falls within the allowable range. That is, the automatic adjustment controller 112 determines whether or not the difference between the sum total of the detection results by all the gain settings at the identical characteristic frequency setting, which are obtained at the consumption current of the initial value (within fields in a lateral direction of FIG. 5), and that of the detection results by all the gain settings at the identical characteristic frequency setting, which are obtained at the predetermined small consumption current (within fields in the lateral direction of FIG. 5), falls within the allowable range. If the difference falls within the allowable range, the automatic adjustment controller 112 decides filter characteristics used in the operation mode based on the predetermined filter setting (predetermined adjustment result) obtained at the predetermined small consumption current.

As the decision method, for example, the filter characteristics may be decided based on the sum total. Although different decision methods are used depending on the filter characteristics (filter type) and reference signal type, a filter setting in which the sum total assumes a maximal value using a reference signal of a desired frequency is selected. For example, in the case of a bandpass filter, a reference signal of the center frequency of the pass band is used, and a filter characteristic control signal corresponding to the maximal sum total at respective characteristic frequencies is selected. For example, when a reference signal of 38 kHz is input to the bandpass filter 102, and when a characteristic frequency of 38 kHz is to be set by a filter characteristic control signal, the sum total of the amplitudes of filter outputs at all amplitudes of reference signals should be maximal. However, assume that the maximal sum total is detected when another characteristic frequency, for example, a characteristic frequency of 37.99 kHz is to be set because of manufacturing variations of the filter characteristics. In this case, a control signal which is to set the characteristic frequency of 37.99 kHz can be selected as a filter characteristic control signal used in the operation mode.

Finally, in block 320, the automatic adjustment controller 112 turns on switches 108 and 110 to input an input signal to the filter 102, and turns off switches 109 and 111 to block input of the reference signal to the filter 102. Then, the automatic filter adjustment apparatus is switched from the adjustment mode to the operation mode.

The first embodiment will be summarized below.

According to the first embodiment, even when the characteristic frequency of the filter varies because of the manufacturing variations of a resistor and capacitor of the filter 102, the output amplitudes of the filter 102 are detected in association with various combinations of amplitudes of reference signals and characteristic frequencies using a plurality of reference signals of different amplitudes generated by the reference signal generator 104 and filter characteristic control signals of a plurality of characteristic frequencies generated by the control signal generator 105, and a filter characteristic control signal which realizes a desired characteristic frequency of the filter can be decided based on the detection results of these amplitudes.

An order of varying the amplitude of the reference signal and the characteristic frequency of the filter is not limited to that shown in FIG. 2 as long as the amplitudes of the filter outputs can be detected in all the combinations. For example, the filter characteristic frequency may be set to be a maximum value in place of a minimum value in block 230 of FIG. 2, and the output amplitude of the reference signal may be set to be a maximum value in place of a minimum value in block 240. However, in this case, the output amplitude of the reference signal is decreased by one level, and the filter characteristic frequency is decreased by one level respectively in blocks 280 and 300.

In place of setting the characteristic frequency of the filter 102 at a certain frequency first to change the output amplitude of the reference signal, as shown in FIG. 2, the output amplitude of the reference signal may be set to be a certain amplitude first to change the characteristic frequency of the filter 102.

The above description describes the reference signal of one type, but reference signals of a plurality of types may be used. For example, a reference signal of a desired frequency (in the case of a bandpass filter, the center frequency of the pass band) and that of another disturbing wave frequency are used, and a filter characteristic control signal, which is to set a characteristic frequency corresponding to a maximum amplitude detection value in association with the reference signal of the desired frequency of those at each of which a ratio between the amplitude detection value when the reference signal of the desired frequency is used and the amplitude detection value of the disturbing wave frequency is greater than or equal to a predetermined value, may be selected.

In blocks 280 and 300, the amplitude and characteristic frequency are changed level by level. Alternatively, a coarse adjustment step of changing either one or both of the output amplitude of the reference signal and the characteristic frequency of the filter 102 by a prescribed value greater than or equal to two levels may be used.

In this case, an adjustment step which changes either one or both of the output amplitude of the reference signal and the characteristic frequency of the filter 102 level by level will be referred to as a fine adjustment step hereinafter. For example, when the output amplitude of the reference signal is changed by two levels or more in the coarse adjustment step, a filter characteristic frequency range which generates a significant difference in the output amplitude detection results (the aforementioned sum total) of the filter 102 can be estimated. Next, by executing the fine adjustment step of changing the output amplitude of the reference signal by one level in association with the filter characteristic frequency range estimated in the coarse adjustment step, a filter characteristic control signal can be adjusted by fewer processes.

Alternatively, when the characteristic frequency to be set by the filter characteristic control signal is changed by two levels or more in the coarse adjustment step, a filter characteristic frequency range which generates a significant difference in the output amplitude detection results (the aforementioned sum total) of the filter 102 can be estimated. Next, by executing the fine adjustment step of changing the characteristic frequency to be set by the filter characteristic control signal by one level in association with the filter characteristic frequency range estimated in the coarse adjustment step, a filter characteristic control signal can be adjusted by fewer processes.

In this way, using the coarse adjustment step of changing either one or both of the two control signals by two levels or more, the adjustment time of the filter 102 can be shortened.

The automatic adjustment controller 112 of the automatic filter adjustment apparatus of the first embodiment sets a plurality of different current values (the initial value and the small current value smaller than the initial value) in the filter 102, and detects adjustment results of the characteristics of the filter 102 at the respective current values. For example, when an adjustment result detected at a current value (small current value) smaller than a reference current value (initial value), which is maximum one of a plurality of current values, satisfies a predetermined condition with respect to a reference adjustment result detected at the reference current value, the automatic adjustment controller 112 sets the current value smaller than the reference current value in the filter 102, and sets a predetermined characteristic control value obtained form the adjustment result in the filter 102. For example, the automatic adjustment controller 112 sets, as the predetermined characteristic control value, a characteristic control value corresponding to filter characteristics at which a sum total of a plurality of amplitudes is maximal from detection results of a plurality of amplitudes of output signals of the filter 102 corresponding to all combinations of a plurality of different frequency characteristics and a plurality of reference signals of different amplitudes. Thus, power savings of the filter can be attained.

The respective units of the automatic filter adjustment apparatus will be described in detail below.

FIG. 6 shows an example of the arrangement of the reference signal generator 104 shown in FIG. 3. The reference signal generator 104 includes a variable gain amplifier (attenuator) 401 used to amplify or attenuate a reference signal of a given amplitude (predetermined frequency). The variable gain amplifier (attenuator) 401 has one or both functions of a variable amplifier and variable attenuator. As the reference signal, a sine wave signal can be used. The gain of the variable gain amplifier 401 is controlled by the amplitude control signal output from the control signal generator 105, and the variable gain amplifier 401 outputs an input signal as a reference signal of an amplitude according to the amplitude control signal. Thus, the reference signal generator 104 can generate reference signals having a plurality of amplitudes according to the amplitude control signal.

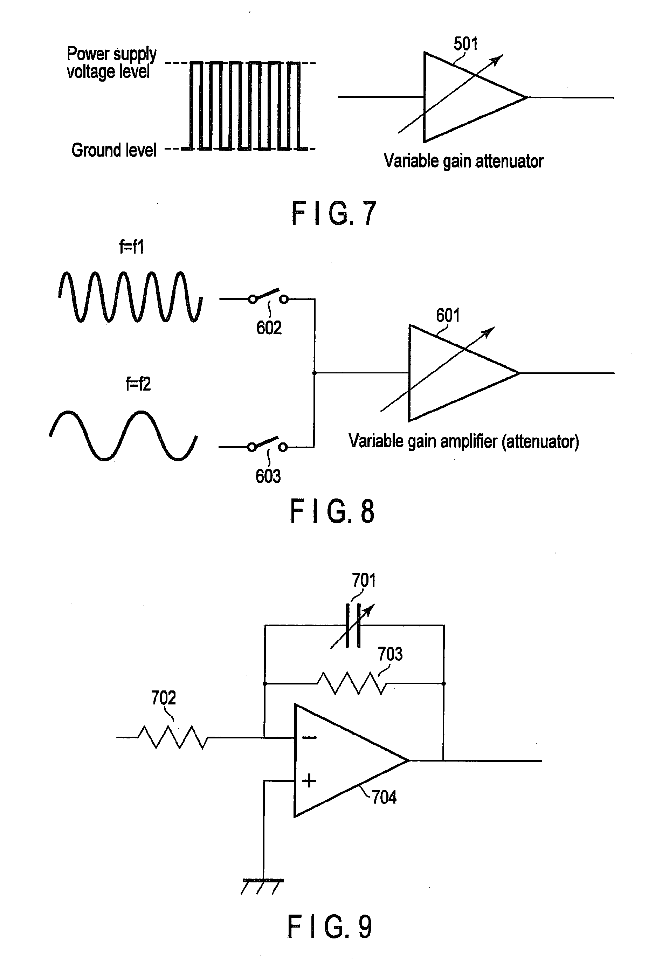

FIG. 7 shows another example of the arrangement of the reference signal generator 104. In this example, as the reference signal, a rectangular wave of a reference frequency including two values, that is, a power supply level and ground level, is used in place of a sine wave signal. Such rectangular wave can be easily obtained from a clock signal used in an oscillator or digital unit. The amplitude of this rectangular wave is adjusted using a variable gain attenuator 501.

Thus, a reference signal can be easily generated from a clock signal used in an oscillator or digital unit.

The aforementioned rectangular wave includes harmonic components. In some cases, the filter may not be appropriately adjusted because of the influence of harmonics. In such case, the reference signal generator 104 may further include a filter required to remove harmonic components.

In addition to the aforementioned examples, a plurality of reference signals of different amplitudes may be generated in advance, and one of these signals may be selected by a switch and the like.

Alternatively, the reference signal generator 104 may have an arrangement, as shown in FIG. 8. That is, a plurality of reference signals of different frequencies are generated in advance, and one of these reference signals is selected by switches 602 and 603, thus inputting the selected signal to a variable gain amplifier (attenuator) 601. FIG. 8 shows reference signals of two different frequencies.

FIG. 9 shows an example of the arrangement of the filter 102, which is shown in FIG. 3, and allows adjustment of its characteristic frequency.

The filter 102 includes a variable capacitor 701, resistors 702 and 703, and operational amplifier 704. An input signal is input to the inverting input terminal of the operational amplifier 704 via the input resistor 702. The non-inverting input terminal is grounded. The variable capacitor 701 and feedback resistor 703 are connected in parallel between the output terminal and the inverting input terminal of the operational amplifier 704.

The characteristic frequency of the filter 102 can be changed by adjusting the value of the variable capacitor 701 according to the filter characteristic control signal from the control signal generator 105.

The variable capacitor 701 may have an arrangement in which, for example, a plurality of capacitors, connections of which are controllable by a switch, are connected in parallel, and the capacitance value is varied by turning that switch on or off.

Alternatively, the resistance values of the resistors 702 and 703 may be variable, and a characteristic frequency may be changed by controlling the resistance values.

The filter 102 may be configured as a Gm-C filter, and the capacitance value of the Gm-C filter or a Gm value of a transconductance amplifier may be controlled.

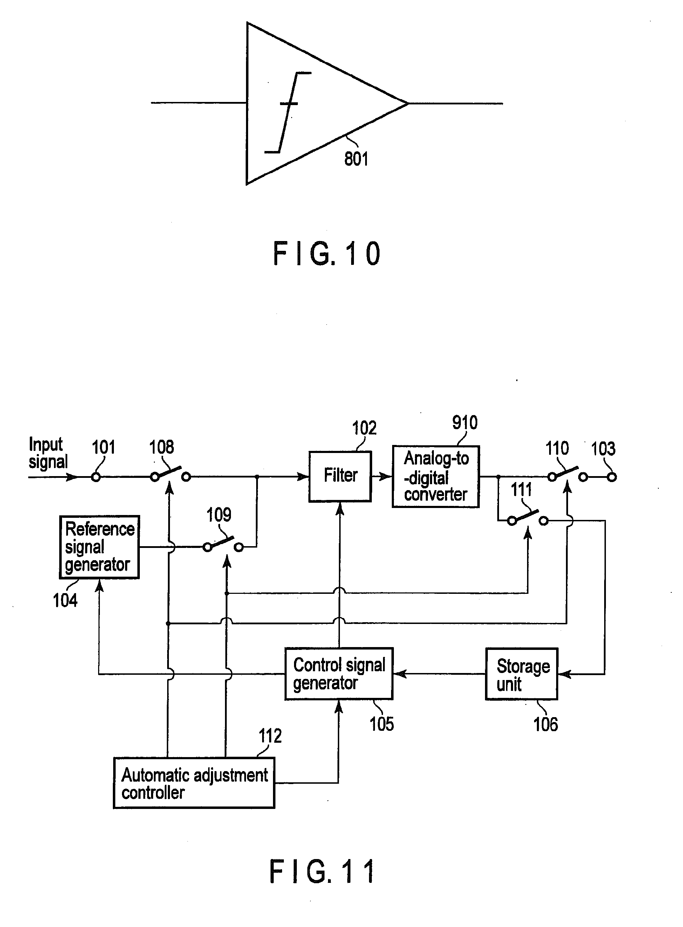

FIG. 10 shows an example of the arrangement of the amplitude detector 107.

The amplitude detector 107 uses a comparator 801. The amplitude of the output signal of the filter 102 is compared with a threshold of the comparator 801 to determine whether or not the detected amplitude is larger than the threshold. This comparator 801 is equivalent to a one-bit analog-to-digital converter. However, as the amplitude detector, an analog-to-digital converter of an arbitrary number of bits may be used.

A rectifier may be used to convert an input signal into a DC component, and the comparator 801 may compare the DC component with a given threshold.

As described above, according to the first embodiment, a filter characteristic control signal required to set filter characteristics to be desired characteristics is decided based on amplitudes of output signals of the filter when a plurality of reference signals of different amplitudes are input to the filter 102 set in a plurality of filter characteristics. Thus, even when the filter characteristics are subject to manufacturing variations due to those of a resistor and capacitor in an integrated circuit, the filter characteristics can be accurately and automatically adjusted without using any phase comparator.

Furthermore, according to the first embodiment, when an adjustment result of filter characteristics based on a current value smaller than a reference current value of a plurality of current values satisfies a preset condition with respect to that of filter characteristics based on the reference current value, the current value smaller than the reference current value is set in the filter 102, thus reducing a power consumption amount.

Other embodiments will be described hereinafter. In the description of other embodiments, the same reference numerals denote the same parts as those in the first embodiment, and a detailed description thereof will not be repeated.

### (Second Embodiment)

FIG. 11 is a block diagram of an automatic filter adjustment apparatus according to the second embodiment.

This embodiment is different from the first embodiment in that an analog-to-digital converter 910 is used in place of the amplitude detector 107, and in its connection. In this embodiment, an output signal of the filter 102 is input to the analog-to-digital converter 910, and the output of the analog-to-digital converter 910 is supplied to the output terminal 103 via switch 110 and also to the storage unit 106 via switch 111. That is, the analog-to-digital converter 910 can be used in both the operation mode and adjustment mode.

In the first embodiment, the dedicated amplitude detector 107 is used to detect the amplitude of the output signal of the filter 102. However, the analog-to-digital converter 910 of this embodiment can be used in digital signal processing in addition to detection of the amplitude of the output signal of the filter 102. That is, the analog-to-digital converter 910 operates as a signal processing circuit when the automatic filter adjustment apparatus is in the operation mode, and as an amplitude detector when the automatic filter adjustment apparatus is in the adjustment mode.

Thus, the automatic filter adjustment can be attained without adding a dedicated amplitude detector to the automatic filter adjustment apparatus.

### (Third Embodiment)

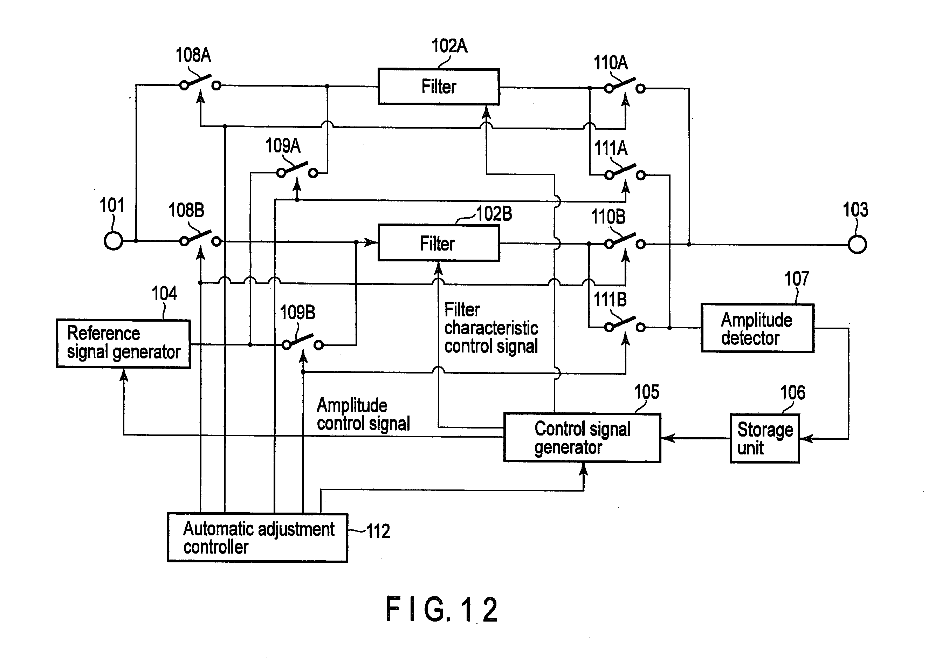

FIG. 12 is a block diagram of an automatic filter adjustment apparatus according to the third embodiment.

In the first and second embodiments, the filter is switched between the adjustment mode and operation mode, and one of the reference signal and input signal is input to the filter. In the adjustment mode, since the input signal is blocked, and the reference signal is input to the filter, a primary operation of the filter cannot be executed. For this reason, a wireless device using the filter cannot execute signal processing in the adjustment mode. In the third embodiment, the two filters having the same arrangement are arranged, and when one filter is in the adjustment mode, the other filter can be used in the operation mode. Note that when one filter is in the operation mode, the other filter need not always be used in the adjustment mode, and may be inactivated if no adjustment is required.

FIG. 12 shows the case in which the two filters are arranged in the first embodiment. Also, the two filters may be arranged in the second embodiment. The input terminal 101 is connected to filters 102A and 102B via switches 108A and 108B. The reference signal generator 104 is connected to filters 102A and 102B via switches 109A and 109B. The output terminal of filter 102A is connected to the output terminal 103 via a switch 110A, and is also connected to the amplitude detector 107 via a switch 111A. The output terminal of filter 102B is connected to the output terminal 103 via a switch 110B, and is also connected to the amplitude detector 107 via a switch 111B.

The operation of this embodiment will be described below. The automatic adjustment controller 112 sets one of filters 102A and 102B in the adjustment mode, and the other in the operation mode. In this case, filter 102A is set in the adjustment mode first, and filter 102B is set in the operation mode. The automatic adjustment controller 112 turns off switches 108A, 110A, 109B, and 111B, and turns on switches 108B, 110B, 109A, and 111A. Thus, filter 102B receives an input signal from the input terminal 101, and operates in the operation mode. Filter 102A receives a reference signal from the reference signal generator 104, and operates in the adjustment mode. The output of filter 102A is supplied to the amplitude detector 107 via switch 111A, thus calculating a filter characteristic control signal used in the operation ode as in the first embodiment.

After that, the automatic adjustment controller 112 turns the switches on or off at a predetermined timing to switch filter 102A from the adjustment mode to the operation mode. Then, filter 102B may be set in the adjustment mode, but it may be set in an inactive mode. In order to set the inactive mode, all switches 108B, 109B, 110B, and 111B connected to the input terminal and output terminal of filter 102B are turned off, so filter 102B does not consume any power.

When filter 102B is set in the inactive mode, filter 102B shifts to the adjustment mode at a predetermined timing. After completion of the automatic adjustment, filter 102B shifts to the operation mode at a predetermined timing, and filter 102A shifts to the adjustment mode or inactive mode.

Thus, even when one filter is in the adjustment mode, since the other filter operates in the operation mode, this embodiment can always execute processing of an input signal from the input terminal 101.

### (Fourth Embodiment)

FIG. 13 is a block diagram according to the fourth embodiment. The fourth embodiment will describe an example of a receiver including an automatic filter adjustment apparatus according to one of the first to third embodiments. For example, a receiver 1001 is built in a target apparatus (for example, the digital television broadcast receiver shown in FIGS. 1 and 2) controlled by a remote controller, and is used as a power supply control system which controls (reduces) consumption power in a standby mode of the control target apparatus.

For example, the receiver 1001 is built in an electronic apparatus 1000, and a power supply 1004 is connected to the electronic apparatus 1000. The power supply 1004 is, for example, an AC power supply of 100 V, and is connected to a control target unit 1006 via a switch 1005. The control target unit 1006 is supplied with electric power from the power supply 1004 when switch 1005 is on. Switch 1005 is turned on or off by a control signal from the control target unit 1006 or that from the receiver 1001. The control target unit 1006 includes a power supply controller 1008 which controls a chargeable power supply unit 1003 based on electric power supplied from the power supply 1004. The chargeable power supply unit 1003 is charged by electric power from the power supply controller 1008. In this case, electric power output from the chargeable power supply unit 1003 is that sufficiently smaller than electric power output from the power supply 1004.

The receiver 1001 includes a photodiode (PD) 1102 which receives an infrared remote control signal from a remote controller transmitter (not shown), an amplifier 1104 which amplifies the output from the PD 1102, a bandpass filter 1106 which receives the output from the amplifier 1104, a code detector 1110 which receives the output from the bandpass filter 1106 via an analog-to-digital converter 1108, and the like. The bandpass filter 1106 extracts subcarrier waves of a PPM-modulated remote control signal. The code detector 1110 detects various control codes included in the remote control signal.

The bandpass filter 1106 is included in an automatic filter adjustment apparatus 1002 described in the first to third embodiments. The receiver 1001 operates based on electric power supplied from the chargeable power supply unit 1003. Therefore, the receiver 1001 can operate by electric power smaller than the control target unit 1006.

The operation of this embodiment will be practically described below. When the control target unit 1006 is in the operation mode, switch 1005 is ON, and the control target unit 1006 receives electric power from the power supply 1004. A predetermined voltage is supplied to the chargeable power supply unit 1103 via the power supply controller 1008 included in the control target unit 1006. For this reason, the chargeable power supply unit 1103 is charged as needed during the operation of the control target unit 1006.

The control target unit 1006 shifts to a standby state when a predetermined condition is satisfied. The predetermined condition includes, for example, a case in which the control target unit 1006 receives a shift instruction to the standby state, a case in which the receiver 1001 receives a remote control signal which shifts the control target unit 1006 to the standby state, and the like. In these cases, the control target unit 1006 or receiver 1001 turns off switch 1005 to disconnect the control target unit 1006 from the power supply 1004. In this manner, the control target unit 1006 does not consume any electric power, and the receiver 1001 operates in the standby state. Since the receiver 1001 operates by electric power form the chargeable power supply unit 1003, it operates by electric power sufficiently smaller than the control target unit 1006, thus reducing power consumption in the standby state.

When the receiver 1001 receives a remote control signal which shifts the control target unit 1006 to the operation state in the standby state, it turns on switch 1005 to connect the power supply 1004 to the control target unit 1006.

In this embodiment, the automatic adjustment of the filter is executed in the operation state of the apparatus. When the automatic adjustment is executed in the standby mode, a signal for shifting the apparatus to the operation state may not be received. When the automatic adjustment is executed in the operation state, a signal for shifting the apparatus to the operation state can be surely received in the standby state.

More specifically, the automatic adjustment is executed within a predetermined time period immediately after the shift to the operation state. When the receiver 1001 has to receive a signal for shifting the operation state to the standby state, it cannot receive this signal during the automatic adjustment. Since the adjustment is executed immediately after the shift to the operation state, the receiver 1001 is restricted that it cannot receive the signal for shifting from the operation state to the standby state immediately after the shift to the operation state. When the operation state and standby state need not be frequently switched, the above restriction does not pose any problem. Likewise, the automatic adjustment of the filter may be executed immediately after the shift from the operation state to the standby state.

Thus, when the control target unit 1006 is in the standby state, power consumption of the control target unit 1006 can be reduced.

Note that all the sequences of the control processes (filter characteristic adjustment process, current setting process, and the like) of the first to fourth embodiments can be implemented by software. For this reason, by installing a program required to execute the sequences of the control processes in a general computer via a computer-readable storage medium storing that program, and executing the installed program, the same effects as in the first to fourth embodiments can be easily achieved.

For example, the digital television broadcast receiver shown in FIGS. 1 and 2 reads the program from a computer-readable storage medium via an optical disk drive 82, and stores the read program in the nonvolatile memory 68, thus completing installation of the program. Alternatively, the digital television broadcast receiver downloads the program via the communication interface 73 and the like, and stores the downloaded program in the nonvolatile memory 68, thus completing installation of the program. Thus, the control module 65 of the digital television broadcast receiver, which corresponds to the computer, executes the sequence of the control processes based on the installed program, thereby easily achieving the same effects as in the first to fourth embodiments.

According to at least one embodiment, an electronic apparatus, filter adjustment apparatus, filter adjustment method, and filter adjustment program, which can reduce power consumption, can be provided.

## Claims

1. A filter adjustment apparatus **characterized by** comprising:
a filter adjustment module (105) configured to set a plurality of current values in a filter, and to detect adjustment results of characteristics of the filter at the plurality of current values; and
a setting module (112) configured to set, when an adjustment result detected at a current value smaller than a reference value of the plurality of current values satisfies a preset condition with respect to a reference adjustment result detected at the reference current value, the current value smaller than the reference current value in the filter.

2. The apparatus of claim 1, **characterized in that** when the adjustment result is included in an allowable range upon comparison between the adjustment result and the reference adjustment result, the setting module is configured to set the current value smaller than the reference current value in the filter.

3. The apparatus of claim 2, **characterized in that** when not les than two adjustment results corresponding to not less than two current values are included in the allowable range, the setting module is configured to set a minimum current value of the not less than two current values in the filter as the current value smaller than the reference current value.

4. The apparatus of claim 1, **characterized in that** the setting module is configured to set a predetermined characteristic control value obtained from the adjustment result in the filter.

5. The apparatus of claim 3, **characterized in that** the filter adjustment module is configured to detect the minimum current value by a linear search.

6. The apparatus of claim 3, **characterized in that** the filter adjustment module is configured to detect the minimum current value by a binary search.

7. The apparatus of any one of claims 1 to 6, **characterized in that** the filter adjustment module is configured to control the filter to a plurality of characteristic frequencies using a plurality of characteristic control values, inputs a plurality of reference signals to the filter in a state in which the filter is controlled to the plurality of characteristic frequencies, and detects the adjustment results including information associated with output amplitudes of the filter in combinations of the plurality of characteristic frequencies and the plurality of reference signals.

8. The apparatus of claim 7, **characterized in that** the filter adjustment module is configured to detect the adjustment result including information associated with a maximum output amplitude of the filter in the combinations of the plurality of characteristic frequencies and the plurality of reference signals.

9. The apparatus of any one of claims 1 to 6, **characterized by** further comprising the filter (102).

10. An electronic apparatus **characterized by** comprising:
a filter (102);
a filter adjustment module (105) configured to set a plurality of current values in the filter, and to detect adjustment results of characteristics of the filter at the plurality of current values;
a setting module (112) configured to set, when an adjustment result detected at a current value smaller than a reference value of the plurality of current values satisfies a preset condition with respect to a reference adjustment result detected at the reference current value, the current value smaller than the reference current value in the filter; and
an output module (103) configured to output a signal processed by the filter.

11. A filter adjustment method **characterized by** comprising:
setting a plurality of current values in a filter (240-280), and detecting adjustment results of characteristics of the filter at the plurality of current values (420); and
setting, when an adjustment result detected at a current value smaller than a reference value of the plurality of current values satisfies a preset condition with respect to a reference adjustment result detected at the reference current value, the current value smaller than the reference current value in the filter (470).
